# EUROPEAN PATENT APPLICATION

(11) **EP 4 848 937 A1**
(43) Date of publication of application: **02.12.2026**
(21) Application number: 26181992.4
(22) Date of filing: 29.05.2026
(51) Int. Cl.: H10D 30/66, H10D 8/00, H10D 30/01, H10D 62/10, H10D 62/832, H10D 84/00, H10D 8/01, H10D 8/60, H10D 64/01

(54) **POWER SEMICONDUCTOR DEVICE INCLUDING TRENCH GATE AND SHIELD REGION**

(30) Priority: 30.05.2025 KR 20250071150
(71) Applicant: Samsung Electronics Co., Ltd., Suwon-si, Gyeonggi-do 16677 (KR)
(72) Inventor: KIM, Taehun, 16677 Suwon-si (KR); PARK, Jeonghwan, 16677 Suwon-si (KR); PARK, Younghwan, 16677 Suwon-si (KR); HONG, Sungtaek, 16677 Suwon-si (KR); YUN, Jeongeun, 16677 Suwon-si (KR); WOO, Sangsu, 16677 Suwon-si (KR); OH, Sewoong, 16677 Suwon-si (KR)
(74) Representative: Marks & Clerk LLP

(57) **Abstract**

A power semiconductor device includes a substrate of a first conductivity type (101); a drift layer of the first conductivity type (102) on the substrate; an upper semiconductor structure (US) on the drift layer and including a first trench (TR1) separating the upper semiconductor structure into a first region (A) and a second region (b), the first region including a well region (105) of a second conductivity type on the drift layer and a source region (107) of the first conductivity type on the well region, and the second region including a shielding region (160) extending to a bottom portion of the first trench; a gate electrode (130) in the first trench; a gate insulating layer (120) between the first trench and the gate electrode; a source electrode (150) including a via electrode (155) extending to the drift layer through a second trench (TR2) in the second region; and an isolation insulating layer (125) between the via electrode and the shielding region.

## Description

### BACKGROUND

### 1. Field

The disclosure relates to a power semiconductor device.

### 2. Description of Related Art

A semiconductor device which operates in high-voltage and high-current environments, and is used in fields which requires high-power switching, such as power conversion, a power converter, an inverter, and the like. A power semiconductor device is basically required to have high breakdown voltage characteristics, and recently, high-speed switching operations have been additionally required. Accordingly, a power semiconductor device using silicon carbide (SiC), having superior high breakdown voltage characteristics compared to silicon (Si), are being studied.

### SUMMARY

An aspect of the disclosure is to provide a power semiconductor device having improved electrical characteristics.

According to an aspect of the disclosure, a power semiconductor device may include a substrate of a first conductivity type; a drift layer of the first conductivity type on the substrate; an upper semiconductor structure on the drift layer and including a first trench, the first trench separating the upper semiconductor structure into a first region and a second region,; a well region of a second conductivity type on the drift layer in the first region; a source region of a first conductivity type on the well region in the first region; a shielding region of the second conductivity type in the second region and contacting the drift layer and extending to a bottom portion of the first trench; a gate electrode in the first trench; a gate insulating layer between an inner surface of the first trench and the gate electrode; a second trench penetrating through the shielding region in the second region; a source electrode connected to the well region and the shielding region, the source electrode including a via electrode extending to the drift layer through the second trench; an isolation insulating layer between the via electrode and the shielding region; and a drain electrode on a lower surface of the substrate.

According to an aspect of the disclosure, a power semiconductor device may include a substrate of a first conductivity type; a drift layer of the first conductivity type on the substrate; an upper semiconductor structure on the drift layer and including a first trench separating the upper semiconductor structure into a first region and a second region in a direction; a well region of a second conductivity type on the drift layer in the first region; a source region of the first conductivity type on the well region in the first region; a shielding region of the second conductivity type in the second region and contacting the drift layer and extending to a bottom portion of the first trench, wherein a concentration of impurities of the second conductivity type in the shielding region is greater than a concentration of impurities of the second conductivity type in the well region; a gate structure including a gate electrode in the first trench, and a gate insulating layer between an inner surface of the first trench and the gate electrode; an interlayer insulating layer on the gate electrode; a second trench penetrating through the shielding region in the second region; a source electrode on the interlayer insulating layer, and connected to the well region and the shielding region, the source electrode including a via electrode extending to the drift layer through the second trench; an isolation insulating layer between the via electrode and the shielding region; and a drain electrode on a lower surface of the substrate.

According to an aspect of the disclosure, a power semiconductor device may be provided, the power semiconductor device including a substrate of a first conductivity type; a drift layer of the first conductivity type on the substrate; an upper semiconductor structure on the drift layer and including a first trench, the first trench separating the upper semiconductor structure into a first region and a second region; a well region of a second conductivity type on the drift layer in the first region; a source region of the first conductivity type on the well region in the first region; a shielding region of the second conductivity type in the second region and contacting the drift layer and extending to a bottom portion of the first trench, wherein a concentration of impurities of the second conductivity type in the well region is greater than a concentration of impurities of the second conductivity type in the shielding region; a gate structure including a gate electrode in the first trench, and a gate insulating layer between an inner surface of the first trench and the gate electrode; an interlayer insulating layer on the gate electrode; a second trench penetrating through a contact region and the well region in the first region, the contact region being on the well region; a source electrode on the interlayer insulating layer, and connected to the well region, the contact region, and the shielding region, the source electrode including a via electrode extending to the drift layer through the second trench; an isolation insulating layer between the via electrode, and the contact region and the well region; and a drain electrode on a lower surface of the substrate.

At least some of the above and other features of the invention are set out in the claims.

### BRIEF DESCRIPTION OF DRAWINGS

The above and other aspects, features, and advantages of the disclosure will be more clearly understood from the following detailed description, taken in conjunction with the accompanying drawings, in which:
FIG. 1 is a perspective view illustrating a power semiconductor device according to an example embodiment of the disclosure;
FIG. 2 is a side cross-sectional view illustrating a region A1 of the power semiconductor device of FIG. 1 taken along line I-I';
FIGS. 3A and 3B are horizontal cross-sectional views illustrating the power semiconductor device of FIG. 2, taken along lines II1-II1' and II2-II2';
FIGS. 4A and 4B are cut-away plan views (or horizontal cross-sectional views) of a power semiconductor device according to an example embodiment of the disclosure;
FIGS. 5A and 5B are cut-away plan views (or horizontal cross-sectional views) of a power semiconductor device according to an example embodiment of the disclosure;
FIGS. 6A, 6B, 6C, 6D, and 6E are cross-sectional views of main processes for illustrating the manufacturing method of the power semiconductor device illustrated in FIG. 2;
FIG. 7 is a plan view of the structure of FIG. 6B, taken along line I3-I3';
FIGS. 8A and 8B are plan views illustrating trench arrays according to various example embodiments of the disclosure;
FIGS. 9 and 10 are cross-sectional views illustrating power semiconductor devices according to various example embodiments of the disclosure;
FIGS. 11A, 11B, 11C, 11D, and 11E are cross-sectional views of major processes for illustrating the manufacturing method of the power semiconductor device of FIG. 10;
FIGS. 12A and 12B are cross-sectional side views illustrating power semiconductor devices according to various example embodiments of the disclosure; and
FIGS. 13A and 13B are cross-sectional side views illustrating power semiconductor devices according to various example embodiments of the disclosure.

### DETAILED DESCRIPTION

Hereinafter, various example embodiments of the disclosure will be described in detail with reference to the attached drawings.

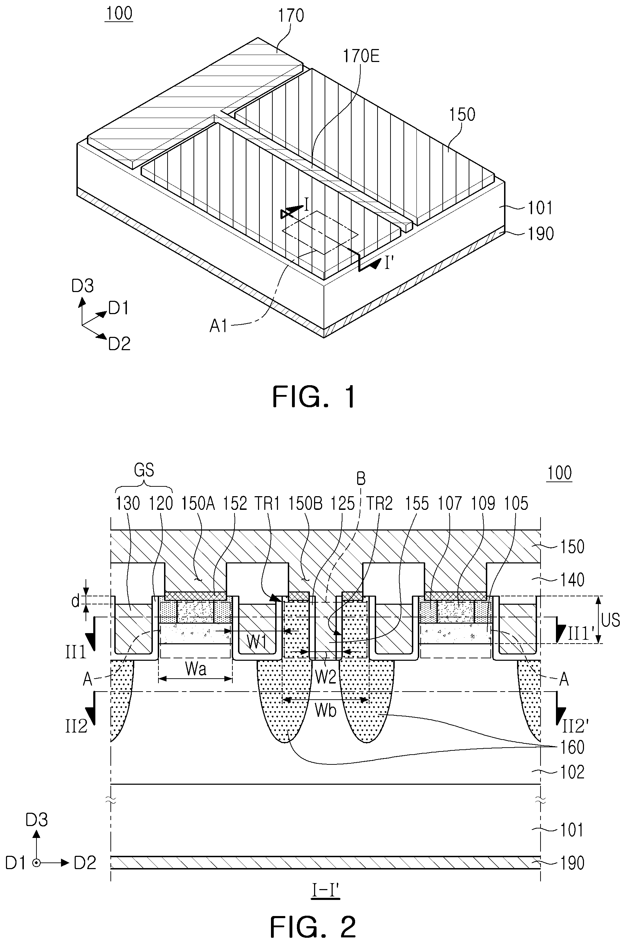

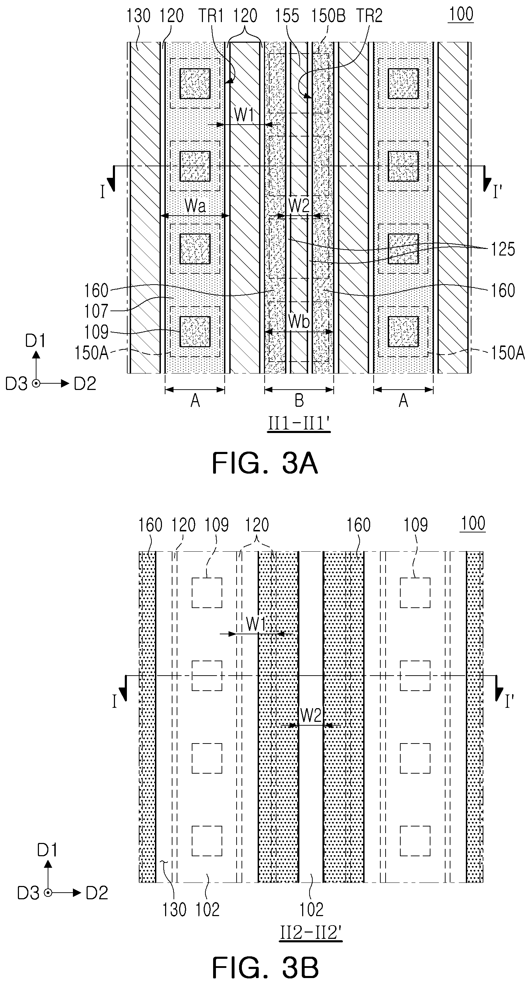

FIG. 1 is a perspective view illustrating a power semiconductor device according to an example embodiment of the disclosure. FIG. 2 is a side cross-sectional view illustrating a region A1 of the power semiconductor device of FIG. 1, taken along line I-I'. FIGS. 3A and 3B are horizontal cross-sectional views illustrating the power semiconductor device of FIG. 2, taken along lines II1-II1' and II2-II2', respectively.

Referring to FIGS. 1 and 2, a power semiconductor device 100 according to an embodiment may include a substrate 101 having a cell region, a source electrode 150 and a gate electrode pad 170 disposed on an upper surface of the substrate 101, and a drain electrode 190 disposed on a lower surface of the substrate 101. In an embodiment, the lower surface of the substrate is opposite the upper surface of the substrate. In an embodiment (see FIG. 2), the source electrode 150 may be configured to be connected to source regions 107. The source electrode 150 may be separated into two electrodes, and the gate electrode pad 170 may include an electrode portion 170E extending between the two source electrodes 150 and connected to a gate electrode 130. An electrode structure of the power semiconductor device 100 is not limited to the structure illustrated in FIG. 1, and may be modified into various electrode arrangements.

FIG. 2 illustrates a cross-section of a cell region of a power semiconductor device 100 according to an embodiment.

Referring to FIG. 2, together with FIG. 1, the power semiconductor device 100 according to an embodiment may include a substrate 101 of a first conductivity type, a drift layer 102 of the first conductivity type on the substrate 101, and an upper semiconductor structure US on the drift layer 102.

The substrate 101 may include a semiconductor material, for example, silicon carbide (SiC). The substrate 101 is not limited thereto. In some example embodiments, the substrate 101 may include a group IV semiconductor material, such as silicon (Si) or germanium (Ge), or a compound semiconductor material, such as silicon-germanium (SiGe), gallium arsenide (GaAs), indium arsenide (InAs), or indium phosphide (InP).

The substrate 101 may be provided as a bulk wafer or an epitaxial layer. The substrate 101 may include impurities of the first conductivity type, and thus may have the first conductivity type. In some example embodiments, the first conductivity type may be N-type, and the impurities of the first conductivity type may be N-type impurities (or N-type dopants), such as nitrogen (N) and/or phosphorus (P). In some example embodiments, the first conductivity type may be P-type, and the impurities of the first conductivity type may be P-type impurities (or P-type dopants), such as aluminum (Al).

The drift layer 102 may be disposed on the substrate 101. The drift layer 102 may include a semiconductor material such as SiC. The drift layer 102 may be formed as an epitaxial layer grown on the substrate 101. The drift layer 102 may include impurities of the first conductivity type. Thus, the drift layer 102 and the substrate 101 may have the same conductivity type. A concentration of the impurities of the first conductivity type in the drift layer 102 may be lower than a concentration of the impurities of the first conductivity type in the substrate 101. In some example embodiments, the concentrations of the impurities of the first conductivity type in the substrate 101 and the drift layer 102 may be the same as each other or different from each other.

The upper semiconductor structure US according to an embodiment may be separated or divided into a first region A and a second region B by a first trench TR1. The first trench TR1 may function as a trench for forming a gate structure GS including the gate electrode 130 and a gate insulating layer 120, and may also be referred to as a "gate trench GT".

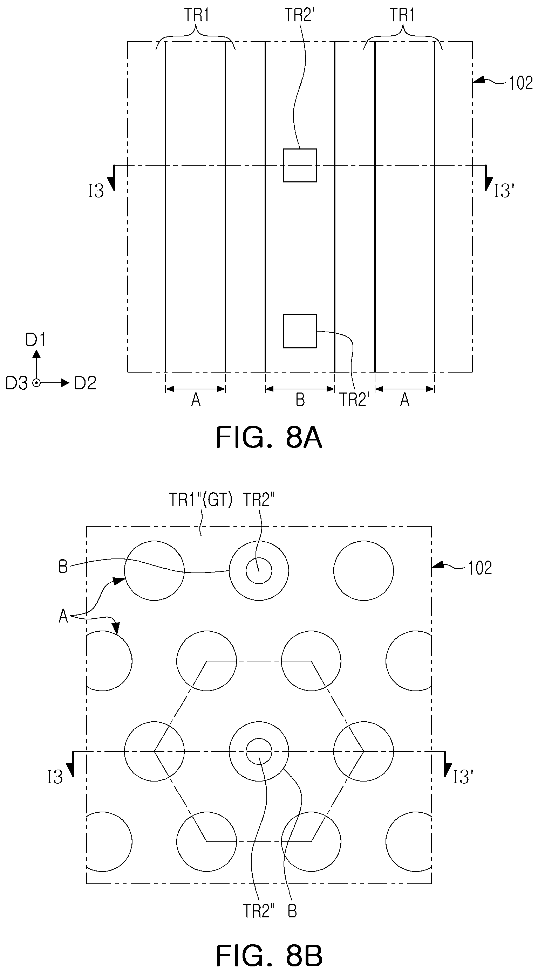

In an embodiment, as illustrated in FIGS. 3A and 3B, the first trench TR1 may extend in a first direction D1, and include a plurality of first trenches spaced apart from each other in a second direction D2, intersecting the first direction D1. The first region A and the second region B may be alternately arranged in the second direction D2. Each of the plurality of first trenches TR1 may be interposed between the first region A and the second region B. In some example embodiments, the first trench TR1 may be modified into various structures (see FIG. 8B).

In an embodiment, a width Wb of the second region B in the second direction D2 may be slightly greater than a width Wa of the first region A in the second direction D2. However, the disclosure is not limited thereto, and in some example embodiments, the width Wa of the first region A and the width Wb of the second region B may be substantially the same as each other, or the width Wa of the first region A may be greater than the width Wb of the second region B.

The first region A and the second region B may include at least one impurity region, which has a different conductivity type or a different concentration. In an embodiment, the first region A may be provided as a field effect transistor (FET) structure together with a gate structure GS, and the second region B may be provided as a diode structure.

First, referring to FIG. 2, the first region A may include a well region 105 a second conductivity type and a source region 107 of the first conductivity type on the well region 105. The first region A may be provided as an FET structure in which a channel is formed in the well region 105, adjacent to the gate structure GS.

The well region 105 may include a semiconductor material such as SiC. The well region 105 may include impurities of the second conductivity type, thereby being a region of the second conductivity type. The second conductivity type may be, for example, P-type, and the impurities of the second conductivity type may be, for example, P-type impurities (or P-type dopants) such as aluminum (Al). The well regions 105 may be regions, in which a counter-doping process (or opposite-type doping process) is performed to a predetermined or certain depth by ion-implantation of the impurities of the second conductivity type from an upper surface of the drift layer 102 of the first conductivity type. In some example embodiments, the well region 105 may include a plurality of impurity regions having different doping concentrations.

The source region 107 may include a semiconductor material such as SiC. The source region 107 may be a region having the first conductivity type, and may include N-type impurities (or N-type dopants), such as nitrogen (N) and/or phosphorus (P). The source region 107 may be a region, in which a counter-doping process (or opposite-type doping process) is performed to a predetermined or certain depth by ion-implanting impurities of the first conductivity type from an upper surface of the well regions 105 of the second conductivity type. In some example embodiments, the concentration of the impurities of the first conductivity type in the source region 107 may be higher than the concentration of the impurities of the first conductivity type in the drift layer 102.

A FET structure of the first region A may further include a well contact region 109. The well contact region 109 may include a semiconductor material such as SiC. The well contact region 109 may be a region having the second conductivity type, and may include P-type impurities (or P-type dopants) such as aluminum (Al). The well contact region 109 may be connected to the well regions 105 on one side or one region of the source regions 107. The well contact regions 109 may be disposed between the well region 105 and the source region 150 so that a voltage from the source electrode 150 may be applied to the well region 105. The concentration of the impurities of the second conductivity type in the well contact region 109 may be higher than the concentration of the impurities of the second conductivity type in the well region 105. In some example embodiments, the well contact region 109 may be formed deeper than the source region 107 and may extend into one region of the well region 105.

Referring to FIGS. 2 and 3A, the power semiconductor device 100 according to an embodiment may include the gate structure GS in the first trench TR1. The gate structure GS may include the gate insulating layer 120 and the gate electrode 130 sequentially formed on an inner wall of the first trench TR1.

The gate electrodes 130 may have a stripe pattern extending in the first direction D1 along the first trench TR1. In an embodiment, the source regions 107 and well regions 105 may be disposed on one side of the gate electrodes 130, and a shielding region 160 may be disposed on the other side of the gate electrodes 130. As illustrated in FIG. 2, the gate electrode 130 may overlap some regions of the source region 107 and the well region 105 in a horizontal direction (e.g., the second direction D2). The gate electrode 130 may have an upper surface at a level lower than that of an upper surface level of the source region 107 by a predetermined or certain distance d. The disclosure is not limited thereto, and in some example embodiments, an upper surface of the gate electrode 130 and the upper surface level of the source region 107 may be substantially at the same level.

The gate electrode 130 may be formed of a conductive material including a semiconductor material such as doped polycrystalline silicon, a metal nitride such as titanium nitride (TiN), tantalum nitride (TaN), or tungsten nitride (WN), and/or a metal material such as aluminum (Al), tungsten (W), or molybdenum (Mo). In some example embodiments, the gate electrode 130 may be formed as two or more multilayer structures.

The gate insulating layer 120 may be disposed between the inner wall of the first trench TR1 and the gate electrode 130. As illustrated in FIG. 2, the gate insulating layer 120 may be disposed between the source region 107, the well region 105, and the drift layer 102, and the gate electrode 130. In some example embodiments, the gate insulating layer 120 may include a plurality of gate insulating films. For example, the gate insulating layer 120 may include oxides, nitrides, or high-κ materials. The high-κ material may include a dielectric material having a higher dielectric constant than a silicon oxide film (SiO₂). The high-κ material may include a dielectric material having a higher dielectric constant than a silicon oxide film (SiO₂). The high-κ material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃).

In the power semiconductor device 100 according to an embodiment, when voltage is applied to the gate electrode 130, a channel may be formed in the well region 105 adjacent to the gate structure GS. Thus, the first region A of the upper semiconductor structure US may function as a FET structure.

The second region B may include the shielding region 160 of the second conductivity type, which contacts the drift layer 102 and extends to the bottom portion of the first trench TR1. In an embodiment, the concentration of the impurities of the second conductivity type in the shielding region 160 may be greater than a concentration of impurities of the second conductivity type in the well region 105. The second region B may be provided as a body diode including the shielding region 160 and the drift layer 102.

The shielding region 160 may be disposed along the gate insulating layer 120 from one side surface of the first trench TR1 to a portion of the bottom portion thereof. The shielding region 160, adjacent to the gate structure GS may effectively disperse an electric field applied to the gate insulating layer 120 when a high voltage (i.e., reverse voltage) is applied, thereby preventing destruction (or dielectric breakdown) of the gate insulating layer 120.

The shielding region 160 has a conductivity type opposite to that of the drift layer 102. In an embodiment, the shielding region 160 may have the second conductivity type, and may include impurities of the second conductivity type. The impurities of the second conductivity type may be P-type impurities (or P-type dopants), such as aluminum (Al), for example. The shielding region 160 may be a region, in which a counter-doping process (opposite-type doping process) is performed to a predetermined or certain depth by ion-implanting the impurities of the second conductivity type.

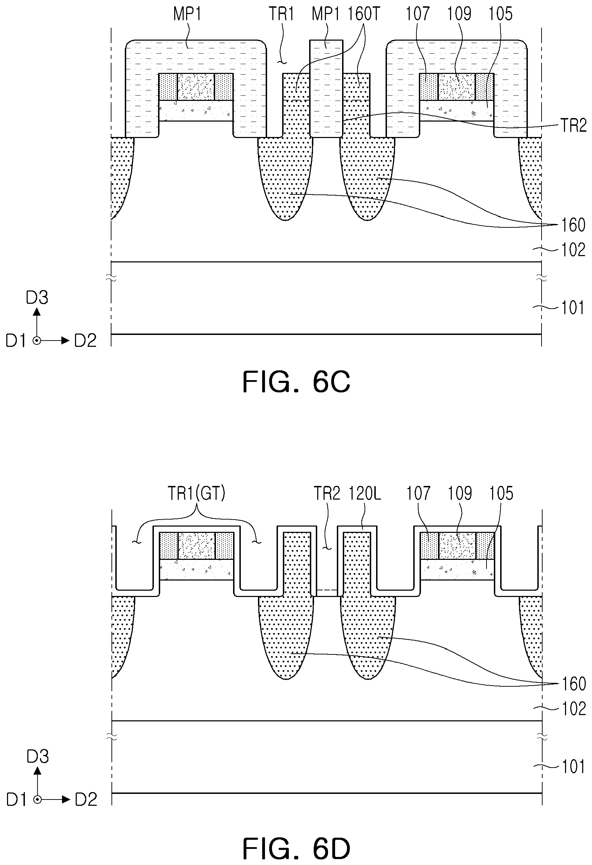

In an embodiment, the shielding region 160 may be formed to a sufficient depth by forming a second trench TR2 before a counter-doping process (or opposite-type doping process). For example, the shielding region 160 may be formed in a region excluding the bottom portion of the second trench TR2 by using a mask pattern (MP1 of FIG. 6C) during the counter-doping process. Thus, as illustrated in FIGS. 2 and 3B, the shielding region 160 may extend to a level lower than that of a bottom level of the gate structure GS, but may not extend below the via electrode 155.

The source electrode 150 according to an embodiment may include the via electrode 155 connected to the drift layer 102 through the second trench TR2 penetrating through the shielding region 160. In an embodiment, the source electrode 150 is directly connected to the drift layer 102 through the second trench TR2. In an embodiment, the bottom portion of the via electrode 155 may be positioned at a level higher than that of a bottom level of the shielding region 160. However, the disclosure is not limited thereto. An isolation insulating layer 125 may be formed between the via electrode 155 and the shielding region 160. The isolation insulating layer 125 may electrically insulate the via electrode 155 from the shielding region 160.

For example, the via electrode 155 penetrating through the shielding region 160 may be connected (e.g., directly connected) to the drift layer 102 in the second region B, so that a Schottky barrier may be added within a body diode. Thus, a forward voltage (Vf) of the power semiconductor device 100 according to an embodiment may be reduced.

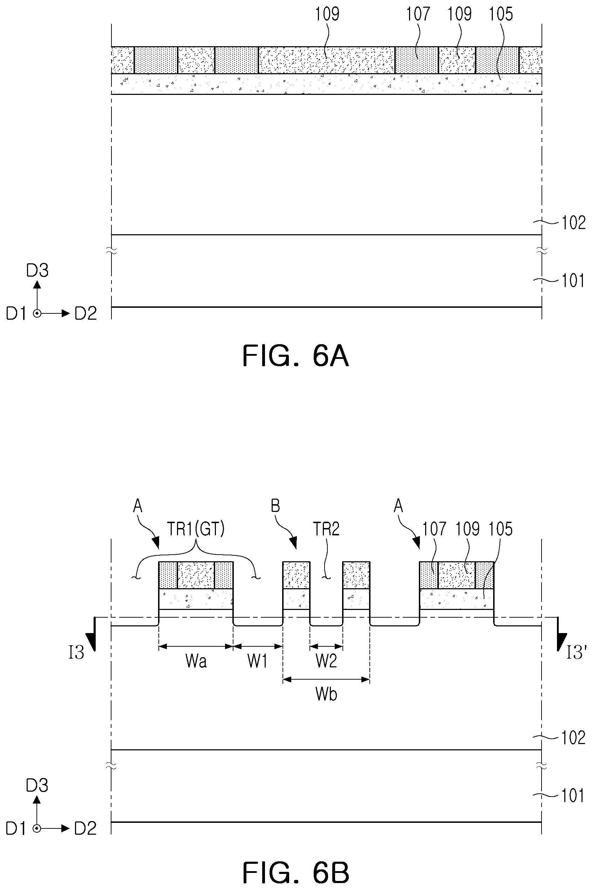

The second trench TR2 according to an embodiment may have a depth substantially equal to that of the first trench TR1, as illustrated in FIG. 2. For example, the bottom portion of the gate structure GS and the bottom portion of the via electrode 155 may be disposed on substantially the same level. It may be understood that the second trench TR2 is formed together with the first trench TR1 during formation of the gate structure GS (see FIG. 6B).

As illustrated in FIGS. 3A and 3B, the shielding region 160 may extend in the first direction D1 along the second region B, and the second trench TR2 may also extend in the first direction D1 from the shielding region 160, similarly to the first trench TR1.

In an embodiment, a width W2 of the second trench TR2 in the second direction D2 may be smaller than a width W1 of the first trench TR1 in the second direction D2. The disclosure is not limited thereto, and in some example embodiments, the width W1 of the first trench TR1 and the width W2 of the second trench TR2 may be substantially the same as each other, or the width W2 of the second trench TR2 may be greater than the width W1 of the first trench TR1.

The power semiconductor device 100 according to an embodiment further includes an interlayer insulating layer 140 on the gate electrode 130. The interlayer insulating layer 140 may cover the gate electrode 130, and may be disposed to expose a portion of each of the source regions 107 (see FIG. 3A). The interlayer insulating layer 140 may cover an upper surface and a side surface of the gate electrode 130, and a side surface of the gate insulating layer 120. The interlayer insulating layer 140 may include an insulating material, and may include at least one of silicon oxide, silicon nitride, and silicon oxynitride.

As illustrated in FIGS. 2 and 3A, a source electrode 150 may be disposed on the interlayer insulating layer 140, and may be electrically connected to the source region 107 and the shielding region 160. The source electrode 150 may include a plurality of first contact regions 150A arranged in the first direction D1 in the first region A, and the plurality of first contact regions 150A may be connected to the source region 107 and the well contact region 109 through a metal-semiconductor compound layer 152. The source electrode 150 may include a plurality of second contact regions 150B arranged in the first direction D1 in the second region B, and the plurality of second contact regions 150B may be connected to the shielding region 160 through the metal-semiconductor compound layer 152.

The source electrode 150 may include at least one of a metal material, for example, nickel (Ni), aluminum (Al), titanium (Ti), silver (Ag), vanadium (V), tungsten (W), cobalt (Co), molybdenum (Mo), copper (Cu), and ruthenium (Ru). The metal-semiconductor compound layer 152 may include a metal element and a semiconductor element, and may include, for example, at least one of TiSi, CoSi, MoSi, LaSi, NiSi, TaSi, or WSi.

For example, the source electrode 150 may include a via electrode 155 that penetrates through the shielding region 160 and is connected to the drift layer 102. In an embodiment, the via electrode 155 may include the same material as the source electrode 150. For example, the via electrode 155 may be connected (e.g., directly connected) to the drift layer 102 to reduce a forward voltage (Vf) of the power semiconductor device 100.

In the example embodiments described above, each of the first trench TR1 and the second trench TR2 is illustrated as extending in one direction (e.g., D1). However, the disclosure is not limited thereto, and a layout of the power semiconductor device may be variously changed according to the first trench TR1 and/or the second trench TR2.

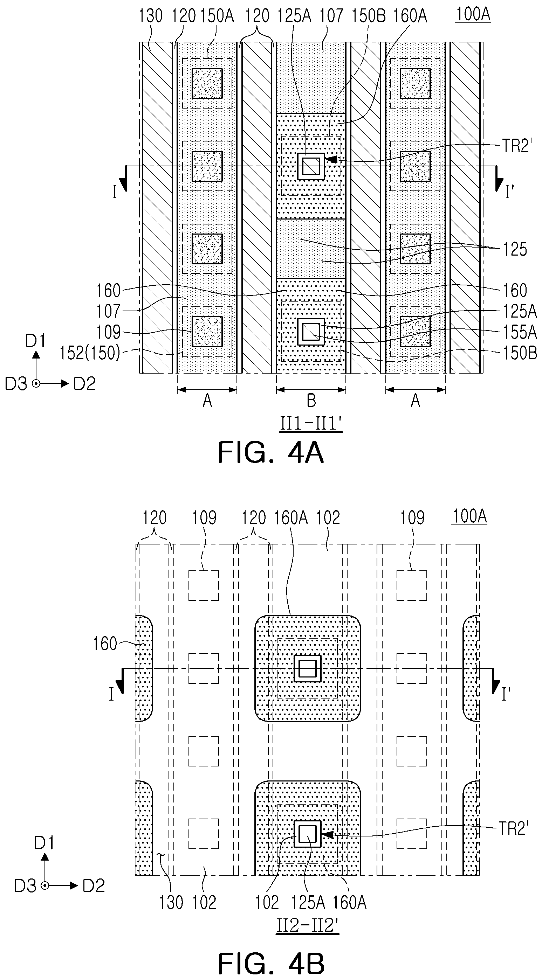

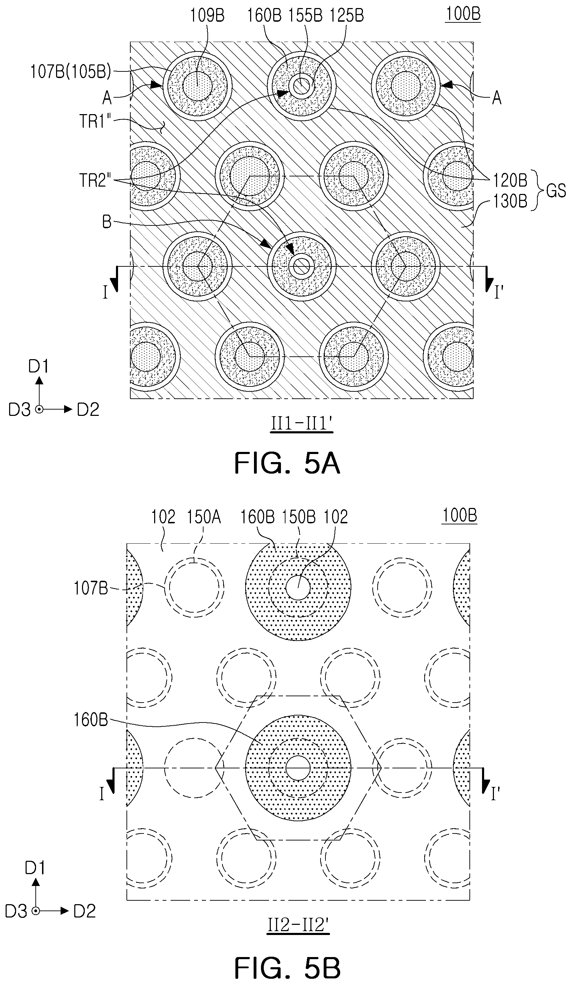

In some example embodiments (see, e.g., FIGS. 4A and 4B), the arrangement of the second trench TR2 (or the via electrode 155) and the shielding region 160A may be variously changed. In some example embodiments (see, e.g., FIGS. 5A and 5B), the arrangement of a first region A and a second region B may be variously changed according to a first trench TR1"

FIGS. 4A and 4B are horizontal cross-sectional views of a power semiconductor device according to an example embodiment of the disclosure. FIGS. 4A and 4B may be understood as cross-sectional planes of the power semiconductor device of FIG. 2 taken along lines II1-II1' and II2-II2', respectively, similar to FIGS. 3A and 3B.

Referring to FIGS. 4A and 4B, it may be understood that a power semiconductor device 100A according to an embodiment is similar to the power semiconductor device 100 illustrated in FIGS. 1, 2, 3A, and 3B, except that a shielding region includes a plurality of shielding regions 160A arranged in the first direction D1 in the second region B, and a second trench TR2' is disposed in each of the plurality of shielding regions 160A. Unless otherwise specifically stated, the components of an embodiment may be understood by referring to the description of the same or similar components of the power semiconductor device 100 illustrated in FIGS. 1, 2, 3A, and 3B.

The power semiconductor device 100A according to an embodiment may include the plurality of shielding regions 160A arranged in the first direction D1 in the second region B. The plurality of shielding regions 160A may be disposed to overlap a portion of FET elements (indicated as "109" or "150A") in the second direction D2. The plurality of shielding regions 160A may be arranged at a pitch different from pitches of the FET elements arranged in the first region A. In another embodiment, the second trench TR2' may be disposed in each of the plurality of shielding regions 160A. A via electrodes 155A in the second trench TR2' may be connected (e.g., directly be connected) to the drift layer 102 by penetrating through the shielding region 160A, and an isolation insulating layer 125A may surround the via electrode 155A such that the via electrode 155A may be electrically insulated from the shielding region 160A.

FIGS. 5A and 5B are horizontal cross-sectional views of a power semiconductor device according to an example embodiment of the disclosure. FIGS. 5A and 5B may be understood as cross-sectional planes of the power semiconductor device of FIG. 2 taken along lines II1-II1' and II2-II2', similar to FIGS. 3A and 3B, respectively.

Referring to FIGS. 5A and 5B, it may be understood that a power semiconductor device 100B according to an embodiment is similar to the power semiconductor device 100 illustrated in FIGS. 1, 2, 3A, and 3B, except that in plan view, a first trench TR1" is arranged in a hexagonal shape while a first region A and a second region B respectively have a circular shape, and the first region A and the second region B" have substantially the same width. Unless otherwise specifically stated, the components of an embodiment may be understood by referring to the description of the same or similar components of the power semiconductor device 100 illustrated in FIGS. 1, 2, 3A, and 3B.

In an embodiment, the first trench TR1" for the gate structure GS may be formed such that a plurality of first regions A and a plurality of second regions B are densely arranged in a hexagonal shape. Each of the plurality of first regions A may be arranged to be adjacent to at least one of the plurality of second regions B. In an embodiment, as illustrated in FIGS. 5A and 5B, six first regions A may be arranged in a hexagonal shape, and one second region B may be disposed at the center of the hexagonal arrangement.

Referring to FIG. 5A, a gate structure GS includes a gate insulating layer 120B and a gate electrode 130B, and may be disposed to surround the first regions A and the second regions B within the first trench TR1".

In an embodiment, each of the plurality of first regions A and the plurality of second regions B may have a circular shape. The first region A and the second region B may have substantially the same width. In each of the plurality of first regions A, a FET structure including a well region 105B on the drift layer 102, a source region 107B on the well region 105B, and a well contact region 109B within the source region 107B may be formed. In the plurality of second regions B, a shielding region 160B may extend to a portion of the bottom portion of the gate structure GS. The shielding region 160B may be in contact with the drift layer 102 to form a body diode.

For example, a second trench TR2" may be connected (or extend) to the drift layer 102 through the shielding region 160B. A via electrode 155B may be connected to the drift layer 102 through the second trench TR2", and may be electrically isolated from the shielding region 160B by an isolation insulating layer 125B. Thus, the via electrode 155B may reduce a forward voltage (Vf) of the power semiconductor device 100B by adding a Schottky junction to the body diode disposed in the second region B.

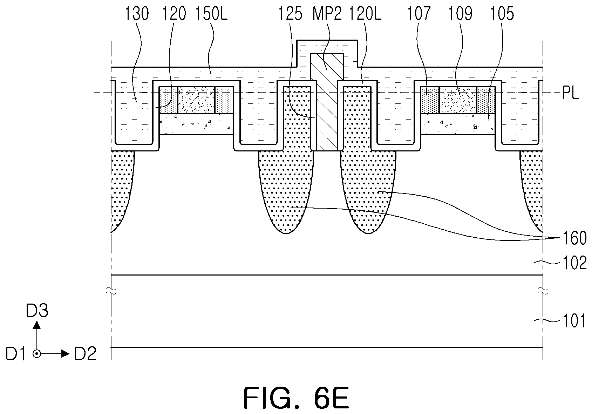

FIGS. 6A, 6B, 6C, 6D, and 6E are cross-sectional views of major processes for illustrating the manufacturing method of the power semiconductor device illustrated in FIG. 2.

First, referring to FIG. 6A, a substrate structure including a substrate 101 of the first conductivity type, a drift layer 102 of the first conductivity type on the substrate 101, a well region 105 of the second conductivity type on the drift layer 102, and a source region 107 of the first conductivity type on the well region 105 may be formed.

The substrate 101 may be provided as, for example, an SiC wafer of the first conductivity type (e.g., N-type). The drift layer 102 may be formed by growing an epitaxial layer of the first conductivity type on the substrate 101. In an embodiment, each of the well region 105 and the source region 107 may be formed in a layer structure by an ion implantation process from an upper surface of the drift layer 102. For example, the well region 105 may be formed by a counter-doping process (opposite-type doping process) using impurities of the second conductivity type using an ion implantation process to a first depth from the upper surface of the drift layer 102. Subsequently, the source region 107 may be formed by counter-doping impurities of the first conductivity type using an ion implantation process to a second depth, which is smaller than the first depth from an upper surface of the well region 105. Next, well contact regions 109 connected to the well region 105 may be formed by a counter-doping process using the impurities of the second conductivity type using an ion implantation process in some regions of the source region 107. The well contact regions 109 may be formed to have different patterns in the first region A and the second region B to be defined in a subsequent process of forming the first trench TR1 (see FIG. 6B). For example, in a region to be the first region A, well contact regions 109 may be formed only in some regions (e.g., a central region) within the source region 107, and in the entire region to be the second region B, the source region 107 may be counter-doped (e.g., entirely counter-doped) to form the well contact regions 109.

Next, referring to FIG. 6B, the first trench TR1 and the second trench TR2 may be formed in the substrate structure using a mask pattern.

The first trench TR1 and the second trench TR2 may be formed by partially removing the source region 107, the well region 105, and the drift layer 102. The upper semiconductor structure may be separated into the first region A and the second region B by the first trench TR1.

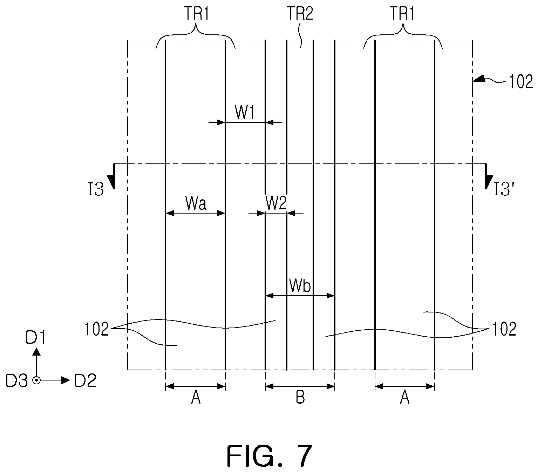

FIG. 7 is a plan view of the substrate structure of FIG. 6B taken along line I3-I3'. Referring to FIG. 7, a first trench TR1 may be formed to extend in the first direction D1, and be spaced apart from each other in the second direction D2, intersecting the first direction D1. The first region A and the second region B may be arranged alternately in the second direction D2 with each of the plurality of first trenches TR1 interposed therebetween.

In an embodiment, a width Wb of the second region B in the second direction D2 may be slightly greater than a width Wa of the first region A in the second direction D2. The disclosure is not limited thereto, and in some example embodiments, the width Wa of the first region A and the width Wb of the second region B may be substantially the same or the width Wa of the first region A may be greater than the width Wb of the second region B.

In an embodiment, the first trenches TR1 may be formed through the well region 105, and a region of the drift layer 102 may be opened (or exposed) at the bottom portion of the first trenches TR1. The second trenches TR2 may provide a space for forming a via electrode for a Schottky junction in the second region B. The second trenches TR2 may be formed together with the first trench TR1. The second trench TR2 may have substantially the same depth as the first trench TR1. The width W2 of the second trench TR2 in the second direction D2 may be smaller than the width W1 of the first trench TR1 in the second direction D2. The disclosure is not limited thereto, and in some example embodiments, the width W1 of the first trench TR1 and the width W2 of the second trench TR2 may be substantially the same as each other, or the width W2 of the second trench TR2 may be greater than the width W1 of the first trench TR1.

The first and second trenches according to an embodiment may have various arrangements. FIGS. 8A and 8B are plan views illustrating first and second trench arrays according to various example embodiments of the disclosure, and may be understood as planes corresponding to FIG. 7.

Referring to FIG. 8A, a plurality of second trenches TR2' may be arranged to be spaced apart from each other in the first direction D1 in the second region B unlike the second trenches TR2 illustrated in FIG. 7. Such an arrangement of the first and second trenches TR1 and TR2 may be understood as a trench arrangement introduced into the power semiconductor device 100A illustrated in FIG. 4A and FIG. 4B.

Referring to FIG. 8B, the first trench TR1" may be formed so that a first region A and a second region B respectively have a circular shape and are arranged in a hexagonal shape/pattern. For example, the first region A and the second region B may have substantially the same width. Six first regions A may be arranged in a hexagonal shape, and one second region B may be disposed at the center of the hexagonal arrangement. The second trench TR2" may be formed to connect to the drift layer 102 through a center of the second region B. In an example embodiment, a depth of the first trench TR1" and a depth of the second trench TR2" may be substantially the same as each other.

Next, referring to FIG. 6C, a shielding region 160 may be formed by ion-implanting impurities of the second conductivity type using a first mask pattern MP1.

The first mask pattern MP1 may be formed to cover the first region A and the second trench TR2. A portion of a second region B and a portion of a first trench TR1, adjacent to the second region B may be opened (or exposed) by the first mask pattern MP1. A shielding region 160 may be formed by ion-implanting impurities of the second conductivity type into the open regions. The shielding region 160 may have a concentration of the impurities of the second conductivity type, which is greater than a concentration of the impurities of the second conductivity type in the well region 105. A well contact region 109 disposed in the open region may be doped with impurities of the second conductivity type at a high concentration to be provided as a portion 160T of the shielding region 160. The shielding region 160 may also be formed in a bottom portion of the first trench TR1 through the first trench TR1, and in a final structure, the shielding region 160 may have a part extending below the gate structure (GS in FIG. 2).

Next, referring to FIG. 6D, after the first mask pattern MP1 is removed, a gate insulating layer 120L may be formed, and a portion of the gate insulating layer (dotted line portion) disposed at the bottom portion of the second trench TR2 may be removed.

For example, the gate insulating layer 120L may be formed on an exposed surface of the substrate structure by a thermal oxidation process. The gate insulating layer 120L may be formed on exposed inner surfaces of the first and second trenches TR1 and TR2 and on upper surfaces of the source region 107 and the well contact region 109. The thermal oxidation process may be performed at high temperatures. For example, the thermal oxidation film formation process may be performed at a temperature within a range of 1300°C to 1900°C.

Next, referring to FIG. 6E, a second mask pattern MP2 may be formed within the second trench TR2, and an electrode layer 150L for a source electrode may be formed to fill in the second trench TR2. Subsequently, the electrode layer 150L may be polished to a certain level PL using a chemical mechanical polishing process. After the polishing process, the gate insulating layer 120 and a gate electrode 130 may be formed within the first trench TR1. Next, after the second mask pattern MP2 is removed, an isolation insulating layer 125 may remain on sidewalls (e.g., opposite sidewalls) of the second trench TR2. The isolation insulating layer 125 may include the same material as the gate insulating layer 120.

In a subsequent process, an interlayer insulating layer 140 may be formed, and contact regions may be opened (or exposed) to form the metal-semiconductor compound layer 152 and a source electrode 150, thereby forming the power semiconductor device 100 as illustrated in FIG. 2. In particular, in a process of forming the source electrode 150, an electrode material may also be filled within the second trench TR2, thereby forming a via electrode 155 connected to the drift layer 102. In an embodiment, the via electrode 155 may include the same material as the source electrode 150.

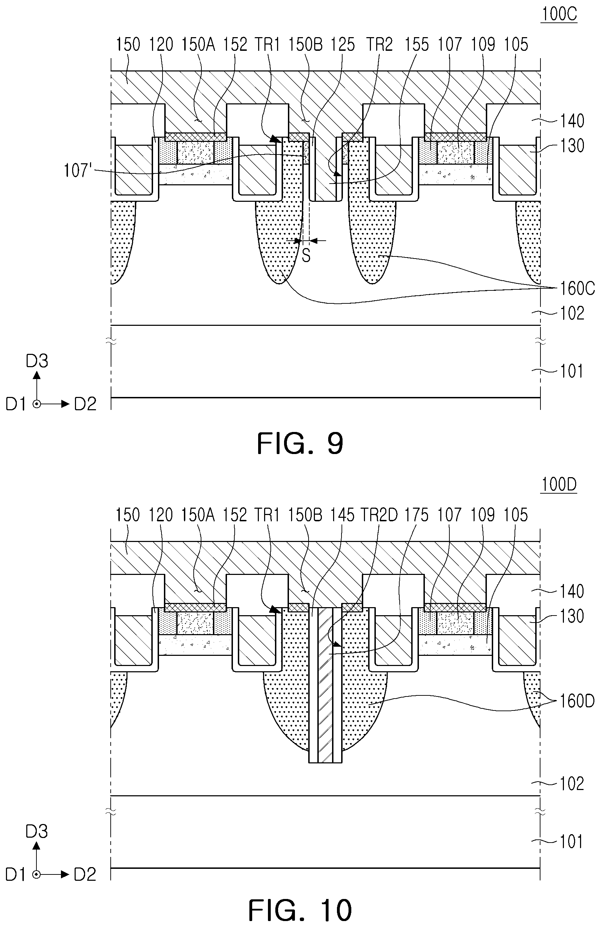

FIG. 9 is a cross-sectional side view illustrating a power semiconductor device according to an example embodiment of the disclosure.

Referring to FIG. 9, it may be understood that a power semiconductor device 100C according to an embodiment is similar to the power semiconductor device 100 illustrated in FIGS. 1, 2, 3A, and 3B, except that a shielding region 160C is formed to be spaced apart from a lower region of the second trench TR2. Unless otherwise specifically stated, the components of an embodiment may be understood by referring to the description of the same or similar components of the power semiconductor device 100 illustrated in FIGS. 1, 2, 3A, and 3B.

In another embodiment, the shielding region 160C may be formed to be spaced apart from the lower region of the second trench TR2 by a certain interval. Referring to FIG. 9, the certain interval may be a certain distance S representing the thickness of a gap between the shielding region 160C and the well contact region 107'. In the process of FIG. 6C, the shielding region 160C spaced apart from the lower region of the second trench TR2 may be formed by extending a portion of the first mask pattern MP1 within the second trench TR2 to a portion of the adjacent well contact region 109. Thus, a well contact region 107' may remain around an upper portion of the via electrode 155. According to an embodiment, since the shielding region 160C is not adjacent to the lower region of the second trench TR2, the via electrode 155 may be more stably connected to the drift layer 102.

FIG. 10 is a cross-sectional side view illustrating a power semiconductor device according to another example embodiment of the disclosure.

Referring to FIG. 10, it may be understood that a power semiconductor device 100D according to an embodiment is similar to the power semiconductor device 100 illustrated in FIGS. 1, 2, 3A, and 3B, except that a shielding region 160D has a different structure (e.g., a cross-sectional shape), a second trench TR2D is formed deeper than a bottom level of the shielding region 160D, an isolation insulating layer 145 includes a material different from that of the gate insulating layer 120, and a via electrode 175 includes an electrode material different from that of the source electrode 150. Unless otherwise specifically stated, the components of an embodiment may be understood by referring to the description of the same or similar components of the power semiconductor device 100 illustrated in FIGS. 1, 2, 3A, and 3B.

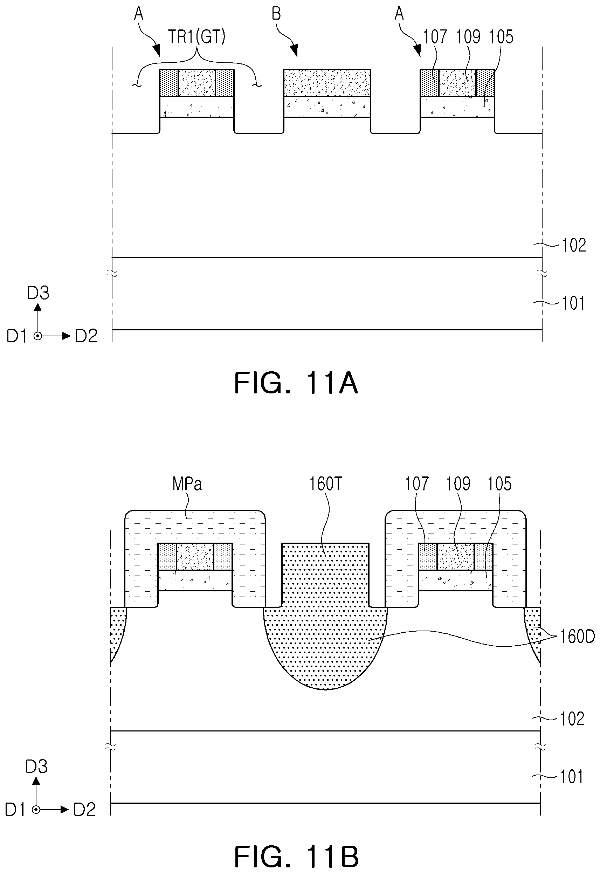

In another embodiment, the shielding region 160D may have a convex sphere shape downwardly. For example, the second trench TR2D may be formed deeper than the bottom level of the shielding region 160D. In another embodiment, the shielding region 160D may be formed in advance before the second trench TR2D is formed (see FIGS. 11B to 11D). The second trench TR2D may be formed through a process separate from that used for forming a first trench TR1. The arrangement of the first and second trenches TR1 and TR2D in plan view may be implemented with reference to FIGS. 3A and 3B, as well as FIGS. 4A and 4B and FIGS. 5A and 5B.

In an embodiment, the isolation insulating layer 145 may be formed of a material different from that of the gate insulating layer 120, and may have a thickness different from that of the gate insulating layer 120. For example, the via electrode 175 may extend lower than the bottom portion of the shielding region 160D and be connected to the drift layer 102. The via electrode 175 according to an embodiment may include an electrode material different from that of the source electrode 150. For example, the via electrode 175 may include tungsten (W), and the source electrode 150 may include titanium (Ti).

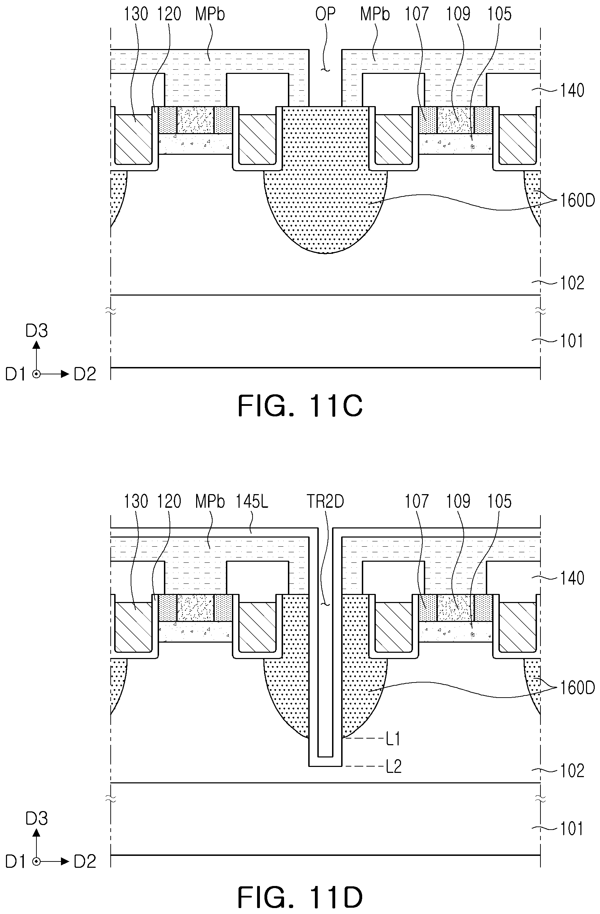

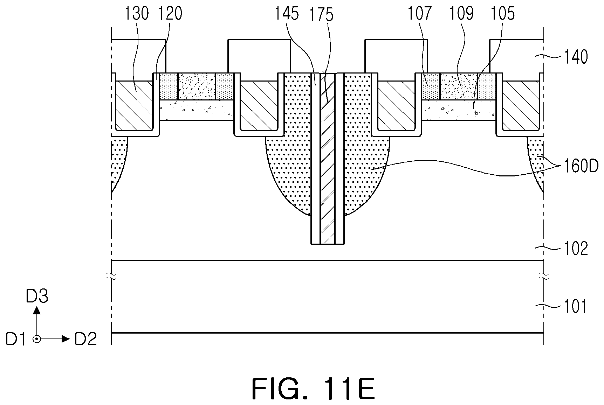

FIGS. 11A, 11B, 11C, 11D, and 11E are cross-sectional views of major processes for illustrating the manufacturing method of the power semiconductor device of FIG. 10.

Referring to FIG. 11A, the first trench TR1 may be formed in the substrate structure illustrated in FIG. 6A.

The first trench TR1 may be formed by partially removing the source region 107, the well region 105, and the drift layer 102. It may be separated into the first region A and the second region B by the first trench TR1.

Next, referring to FIG. 11B, a first mask pattern MPa may be formed, and a shielding region 160D may be formed by ion-implanting impurities of the second conductivity type using the first mask pattern MPa.

The first mask pattern MPa may be formed to cover the first region A and the portion of the first trench TR1, adjacent to the first region A. The second region B and other portions of the first trench TR1, adjacent to the second region B may be opened (or exposed) by the mask pattern MPa. A shielding region 160D may be formed by ion-implanting impurities of the second conductivity type into the open regions. The shielding region 160D may have a concentration of the impurities of the second conductivity type greater than the concentration of the impurities of the second conductivity type in the well region 105. The well contact region 109 disposed in the second region B may be doped with a high concentration of impurities of the second conductivity type to be provided as a portion 160T of the shielding region 160D. The shielding region 160D may also be formed in the bottom portion of the first trench TR1 through the first trench TR1, and in a final structure, the shielding region 160D may have a part extending below the gate structure (GS in FIG. 10).

Next, referring to FIG. 11C, after removing the first mask pattern MPa, the gate insulating layer 120 and the gate electrode 130 may be formed in the first trench TR1. Then, the interlayer insulating layer 140 may be formed, and then a second mask pattern MPb having an opening OP may be formed. A portion of the shielding region 160D may be opened (or exposed) through the opening OP.

Next, referring to FIG. 11D, the second trench TR2D may be formed using a second mask pattern MPb, and an isolation insulating layer 145L may be formed on an inner surface of the second trench TR2D. The second trench TR2D may have a depth of the first trench TR1, as well as a level L2 lower than a bottom level L1 of the shielding region 160D. The isolation insulating layer 145L may be formed of a material different from that of the gate insulating layer 120.

Next, referring to FIG. 11E, a portion of the isolation insulating layer 145L may be removed from the bottom portion of the second trench TR2D using anisotropic etching to form a desired isolation insulating layer 145, and an electrode material may also be filled within the second trench TR2D to form a via electrode 175 connected to the drift layer 102. Subsequently, the second mask pattern MPb may be removed.

As a subsequent process, a process of forming the source electrode 150 may be performed. For example, by opening contact regions to form the metal-semiconductor compound layer 152 and the source electrode 150, a power semiconductor device 100D illustrated in FIG. 10 may be formed. In an embodiment, the via electrode 175 may be formed of a material different from that of the source electrode 150.

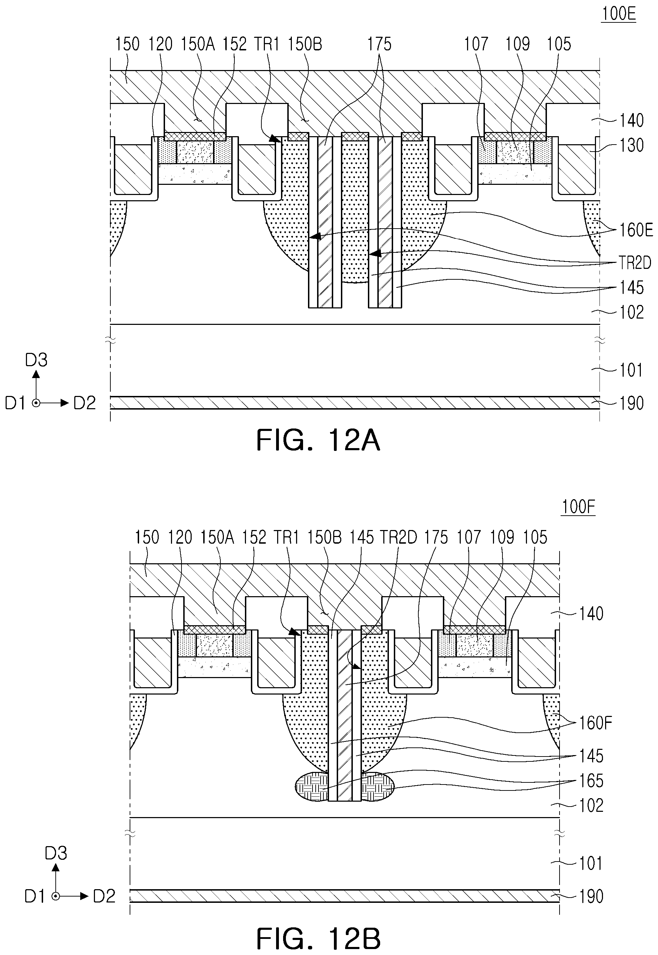

FIGS. 12A and 12B are cross-sectional side views illustrating power semiconductor devices according to various example embodiments of the disclosure.

Referring to FIG. 12A, it may be understood that a power semiconductor device 100E according to an embodiment is similar to the power semiconductor device 100D illustrated in FIG. 10, except that a plurality (e.g., two) second trenches TR2D are formed in a shielding region 160E. Unless otherwise specifically stated, the components of an embodiment may be understood by referring to the descriptions of the same or similar components of the power semiconductor devices 100 and 100D illustrated in FIGS. 1, 2, 3A, and 3B and FIG. 10.

In an embodiment, a plurality of second trenches TR2D may be formed in the shielding region 160E, and a plurality of via electrodes 175 connected to the drift layer 102 through the second trenches TR2D may be formed. Similar to the example embodiment illustrated in FIG. 10, the plurality of via electrodes 175 may be formed to a depth greater than that of a bottom level of the shielding region 160E.

Referring to FIG. 12B, it may be understood that a power semiconductor device 100F according to an embodiment is similar to the power semiconductor device 100D illustrated in FIG. 10, except that an additional shielding region 165 is formed below the shielding region 160F. Unless otherwise specifically stated, the components of an embodiment may be understood by referring to the descriptions of the same or similar components of the power semiconductor devices 100 and 100D illustrated in FIGS. 1, 2, 3A, and 3B and FIG. 10.

An auxiliary shielding region 165 according to an embodiment may be formed around the second trench TR2D below the shielding region 160F. The auxiliary shielding region 165 may be formed after the shielding region 160F is formed. The auxiliary shielding region 165 may be formed as a deep impurity region using an additional ion doping process. In some example embodiments, the auxiliary shielding region 165 may be formed using the second trench TR2D after the second trench TR2D is formed (see FIG. 11D).

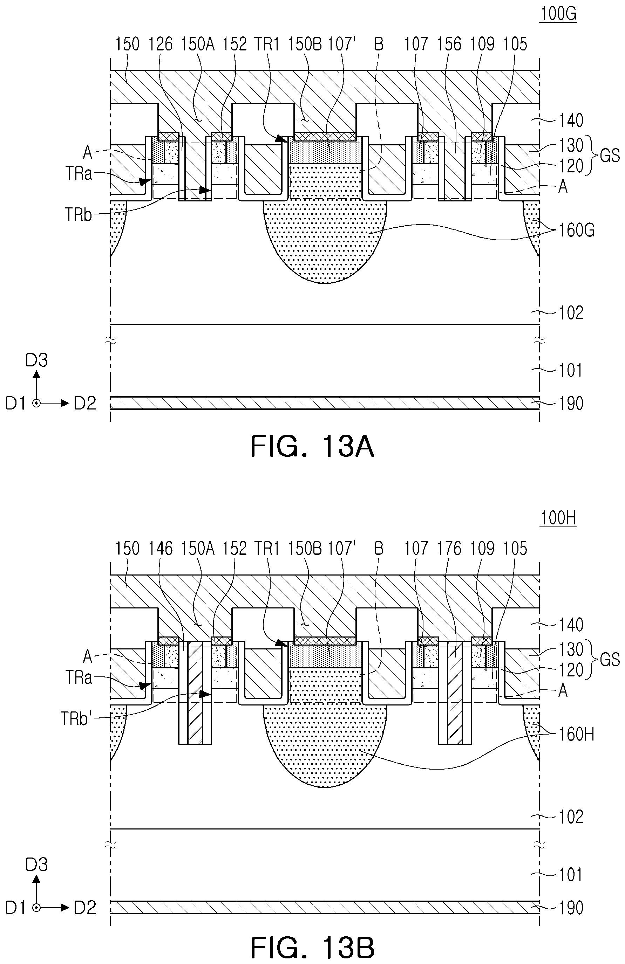

In the example embodiments described above, since a concentration of impurities of the second conductivity type in the shielding region is greater than a concentration of impurities of the second conductivity type in the well region, a body diode may be formed in a region in contact with a shielding region and a drift layer, and therefore, a via electrode for a Schottky junction may be formed to be connected to the drift layer through the shielding region. In contrast thereto, when the concentration of the impurities of the second conductivity type in the well region is greater than the concentration of the impurities of the second conductivity type in the shielding region, a body diode may be formed in the first region, so that a via electrode for a Schottky junction may be formed through a contact region and a well region. FIGS. 13A and 13B are cross-sectional side views illustrating power semiconductor devices according to various example embodiments of the disclosure.

Referring to FIG. 13A, it may be understood that a power semiconductor device 100G according to an embodiment is similar to the power semiconductor device 100 illustrated in FIGS. 1, 2, 3A, and 3B, except that a concentration of impurities of the second conductivity type of the well region 105 is greater than a concentration of impurities of the second conductivity type a shielding region 160G, and a via electrode 156 is connected to the drift layer 102 through the well contact region 109 and the well region 105, and the via electrode 156 remains in a well contact region 107' above the shielding region 160G. Unless otherwise specifically stated, the components of an embodiment may be understood by referring to the description of the same or similar components of the power semiconductor device 100 illustrated in FIGS. 1, 2, 3A, and 3B.

In an embodiment, a concentration of the impurities of the second conductivity type in the well region 105 may be greater than a concentration of the impurities of the second conductivity type in the shielding region 160G. In another embodiment, a body diode may be formed in the first region A, rather than the second region. The body diode may be provided in a region in which the well contact region 109 and the well region 105 and the drift layer 102 are in contact with each other.

In an embodiment, the via electrode 156 may be connected to the drift layer 102 through the well contact region 109 and the well region 105. Thereby, a forward voltage (Vf) of the power semiconductor device 100G may be lowered by adding a Schottky junction to the body diode. As illustrated in FIG. 13A, a depth of a second trench TRb for forming the via electrode 156 and a depth of a first trench TRa for the gate structure GS may be substantially the same as each other. The first and second trenches TRa and TRb may be formed using the same etching process.

Since an isolation insulating layer 126 may be formed together with the gate insulating layer 120, the isolation insulating layer 126 and the gate insulating layer 120 may include the same material. The via electrode 156 may be formed by filling the second trench TRb in a process of forming the source electrode 150, and the via electrode 156 and the source electrode 150 may include the same material.

Since the concentration of the impurities of the second conductivity type in the well region 105 is greater than the concentration of the impurities of the second conductivity type in the shielding region 160G, the impurities of the second conductivity type may remain in a well contact region 107' on a shielding region 160G even after the shielding region 160G is formed.

Referring to FIG. 13B, it may be understood that a power semiconductor device 100H according to an embodiment is similar to the power semiconductor device 100G illustrated in FIG. 13A, except that a second trench TRb' is formed deeper than a bottom level of the first trench TRa, an isolation insulating layer 146 includes a different material from that of the gate insulating layer 120, and the via electrode 176 includes a different electrode material from that of the source electrode 150. Unless otherwise specifically stated, the components of an embodiment may be understood by referring to the description of the same or similar components of the power semiconductor device 100 and 100G illustrated in FIGS. 1, 2, 3A and 3B and FIG. 13A.

A second trench TRb' according to an embodiment may be formed deeper than a bottom level of the first trench TRa. The second trench TRb' may be formed through a process from that used for forming the first trench TRa. The arrangement of the first and second trenches TRa' and TRb in plan view may be implemented with reference to FIGS. 3A and 3B, as well as FIGS. 4A and 4B and FIGS. 5A and 5B.

In an embodiment, the isolation insulating layer 146 may be formed of a different material from that of the gate insulating layer 120, and may have a thickness different from the thickness of the gate insulating layer 120. For example, the via electrode 176 may be connected to the drift layer 102 by extending deeper than the depth of the via electrode 156. In another example, the via electrode 176 may include a different electrode material from that of the source electrode 150. For example, the via electrode 176 may include tungsten (W), and the source electrode 150 may include titanium (Ti).

According to some example embodiments described above, a Schottky barrier may be added within a body diode by forming a via electrode penetrating through a shielding region to be directly connected to a drift layer. Thus, a forward voltage (Vf) of the power semiconductor device 100 according to an embodiment may be reduced.

The various and beneficial advantages and effects of the disclosure are not limited to the above-described content, and may be more easily understood through description of specific embodiments of the disclosure.

Embodiments are set out in the following clauses:
Clause 1. A power semiconductor device, comprising: a substrate of a first conductivity type; a drift layer of the first conductivity type on the substrate; an upper semiconductor structure on the drift layer and comprising a first trench, the first trench separating the upper semiconductor structure into a first region and a second region; a well region of a second conductivity type on the drift layer in the first region; a source region of the first conductivity type on the well region in the first region; a shielding region of the second conductivity type in the second region, the shieling region contacting the drift layer and extending to a bottom portion of the first trench; a gate electrode in the first trench; a gate insulating layer between an inner surface of the first trench and the gate electrode; a second trench penetrating through the shielding region in the second region; a source electrode connected to the well region and the shielding region, the source electrode comprising a via electrode extending to the drift layer through the second trench; an isolation insulating layer between the via electrode and the shielding region; and a drain electrode on a lower surface of the substrate.
Clause 2. The power semiconductor device of Clause 1, wherein a concentration of impurities of the second conductivity type in the shielding region is greater than a concentration of impurities of the second conductivity type in the well region.
Clause 3. The power semiconductor device of Clause 1 or 2, wherein the first trench and the second trench have a same depth.
Clause 4. The power semiconductor device of any preceding Clause, wherein the gate insulating layer and the isolation insulating layer comprise a same material.
Clause 5. The power semiconductor device of any preceding Clause, wherein the via electrode and the source electrode comprise a same material.
Clause 6. The power semiconductor device of any preceding Clause, wherein the first trench extends in a first direction in plan view, and comprises a plurality of first trenches spaced apart in a second direction, intersecting the first direction, and wherein the first region and the second region respectively comprise a plurality of first regions and a plurality of second regions, wherein the plurality of first and second regions are alternately arranged in the second direction with each of the plurality of first trenches interposed between the plurality of first and second regions.
Clause 7. The power semiconductor device of Clause 6, wherein the shielding region extends in the first direction in each of the plurality of second regions.
Clause 8. The power semiconductor device of Clause 7, wherein the second trench extends in the first direction in the shielding region.
Clause 9. The power semiconductor device of Clause 6, 7 or 8, wherein the shielding region comprises a plurality of shielding regions arranged in the first direction in each of the plurality of second regions.
Clause 10. The power semiconductor device of Clause 9, wherein the second trench comprises a plurality of second trenches respectively penetrating through the plurality of shielding regions.
Clause 11. The power semiconductor device of any preceding Clause, wherein the first region and the second region respectively comprise a plurality of first regions and a plurality of second regions, and each of the plurality of first regions is adjacent to at least one of the plurality of second regions.
Clause 12. The power semiconductor device of any preceding Clause, wherein the second trench has a depth less than a bottom level of the shielding region.
Clause 13. The power semiconductor device of any preceding Clause, wherein the shielding region is spaced apart from a lower region of the second trench.
Clause 14. The power semiconductor device of any of Clauses 1 to 11 and Clause 13, wherein the second trench is deeper than a bottom level of the shielding region.
Clause 15. The power semiconductor device of any preceding Clause, wherein the second trench comprises a plurality of second trenches penetrating through the shielding region.
Clause 16. The power semiconductor device of any preceding Clause, further comprising: an auxiliary shielding region of the second conductivity type around the second trench below the shielding region.
Clause 17. A power semiconductor device, comprising: a substrate of a first conductivity type; a drift layer of the first conductivity type on the substrate; an upper semiconductor structure on the drift layer and comprising a first trench separating the upper semiconductor structure into a first region and a second region in a direction; a well region of a second conductivity type on the drift layer in the first region; a source region of the first conductivity type on the well region in the first region; a shielding region of the second conductivity type in the second region, the shielding region contacting the drift layer and extending to a bottom portion of the first trench, wherein a concentration of impurities of the second conductivity type in the shielding region is greater than a concentration of impurities of the second conductivity type in the well region; a gate structure comprising a gate electrode in the first trench, and a gate insulating layer between an inner surface of the first trench and the gate electrode; an interlayer insulating layer on the gate electrode; a second trench penetrating through the shielding region in the second region; a source electrode on the interlayer insulating layer, and connected to the well region and the shielding region, the source electrode comprising a via electrode extending to the drift layer through the second trench; an isolation insulating layer between the via electrode and the shielding region; and a drain electrode on a lower surface of the substrate.
Clause 18. The power semiconductor device of Clause 17, wherein a width of the first region in the direction is different from a width of the second region in the direction.
Clause 19. The power semiconductor device of Clause 17 or 18, wherein a width of the first trench in the direction is different from a width of the second trench in the direction.
Clause 20. A power semiconductor device, comprising: a substrate of a first conductivity type; a drift layer of the first conductivity type on the substrate; an upper semiconductor structure on the drift layer and comprising a first trench, the first trench separating the upper semiconductor structure into a first region and a second region; a well region of a second conductivity type on the drift layer in the first region; a source region of the first conductivity type on the well region in the first region; a shielding region of the second conductivity type in the second region, the shielding region contacting the drift layer and extending to a bottom portion of the first trench, wherein a concentration of impurities of the second conductivity type in the well region is greater than a concentration of impurities of the second conductivity type in the shielding region; a gate structure comprising a gate electrode in the first trench, and a gate insulating layer between an inner surface of the first trench and the gate electrode; an interlayer insulating layer on the gate electrode; a second trench penetrating through a contact region and the well region in the first region, the contact region being on the well region; a source electrode on the interlayer insulating layer, and connected to the well region, the contact region, and the shielding region, the source electrode comprising a via electrode extending to the drift layer through the second trench; an isolation insulating layer between the via electrode, and the contact region and the well region; and a drain electrode on a lower surface of the substrate.

While example embodiments have been illustrated and described above, it will be apparent to those skilled in the art that modifications and variations could be made without departing from the scope of the disclosure as defined by the appended claims.

## Claims

1. A power semiconductor device (100), comprising:
a substrate (101) of a first conductivity type;
a drift layer (102) of the first conductivity type on the substrate (101);
an upper semiconductor structure (US) on the drift layer (102) and comprising a first trench (TR1), the first trench (TR1) separating the upper semiconductor structure (US) into a first region (A) and a second region (B);
a well region (105) of a second conductivity type on the drift layer (102) in the first region (A);
a source region (107) of the first conductivity type on the well region (105) in the first region (A);
a shielding region (160) of the second conductivity type in the second region (B), the shielding region (160) contacting the drift layer (102) and extending to a bottom portion of the first trench (TR1);
a gate electrode (130) in the first trench (TR1);
a gate insulating layer (120) between an inner surface of the first trench (TR1) and the gate electrode (130);
a second trench (TR2) penetrating through the shielding region (160) in the second region (B);
a source electrode (150) connected to the well region (105) and the shielding region (160), the source electrode (150) comprising a via electrode (155) extending to the drift layer (102) through the second trench (TR2);
an isolation insulating layer (125) between the via electrode (155) and the shielding region (160); and
a drain electrode (190) on a lower surface of the substrate (101).

2. The power semiconductor device of claim 1, wherein a concentration of impurities of the second conductivity type in the shielding region (160) is greater than a concentration of impurities of the second conductivity type in the well region (105).

3. The power semiconductor device of claim 1 or 2, wherein the first trench (TR1) and the second trench (TR2) have a same depth.

4. The power semiconductor device of any preceding claim, wherein the gate insulating layer (120) and the isolation insulating layer (125) comprise a same material.

5. The power semiconductor device of any preceding claim, wherein the via electrode (155) and the source electrode (150) comprise a same material.

6. The power semiconductor device of any preceding claim, wherein the first trench (TR1) extends in a first direction (D1) in plan view, and comprises a plurality of first trenches spaced apart in a second direction (D2), intersecting the first direction (D1), and
wherein the first region (A) and the second region (B) respectively comprise a plurality of first regions (A) and a plurality of second regions (B), wherein the plurality of first (A) and second (B) regions are alternately arranged in the second direction (D2) with each of the plurality of first trenches (TR1) interposed between the plurality of first (A) and second (B) regions.

7. The power semiconductor device of claim 6, wherein the shielding region (160) extends in the first direction (D1) in each of the plurality of second regions (B).

8. The power semiconductor device of claim 7, wherein the second trench (TR2) extends in the first direction (D1) in the shielding region (160).

9. The power semiconductor device of claim 6, 7 or 8, wherein the shielding region (160) comprises a plurality of shielding regions (160) arranged in the first direction (D1) in each of the plurality of second regions (B), and the second trench (TR2) comprises a plurality of second trenches (TR2) respectively penetrating through the plurality of shielding regions (160).

10. The power semiconductor device of any preceding claim, wherein the first region (A) and the second region (B) respectively comprise a plurality of first regions (A) and a plurality of second regions (B), and each of the plurality of first regions (A) is adjacent to at least one of the plurality of second regions (B).

11. The power semiconductor device of any preceding claim, wherein the second trench (TR2) has a depth less than a bottom level of the shielding region (160).

12. The power semiconductor device of any preceding claim, wherein the shielding region (160C) is spaced apart from a lower region of the second trench (TR2).

13. The power semiconductor device of any of claims 1 to 10 or claim 12, wherein the second trench (TR2D) is deeper than a bottom level (L1) of the shielding region (160D).

14. The power semiconductor device of any preceding claim, wherein the second trench (TR2) comprises a plurality of second trenches (TR2) penetrating through the shielding region (160).

15. The power semiconductor device of any preceding claim, further comprising:
an auxiliary shielding region (165) of the second conductivity type around the second trench (TR2D) below the shielding region (160F).
